# EUROPÄISCHE PATENTSCHRIFT

(11) **EP 3 208 850 B1**
(45) Veröffentlichungstag und Bekanntmachung des Hinweises auf die Patenterteilung: **04.08.2021**
(21) Anmeldenummer: 16156012.3
(22) Anmeldetag: 16.02.2016
(51) Int. Cl.: H01L 27/146

(54) **HDR PIXEL**
HDR PIXEL
PIXEL HDR

(43) Veröffentlichungstag der Anmeldung: 23.08.2017
(60) Teilanmeldung: 17164857.9
(73) Patentinhaber: Espros Photonics AG, 7320 Sargans (CH)
(72) Erfinder: De Coi, Beat, 7304 Maienfeld (CH)
(74) Vertreter: Otten, Roth, Dobler & Partner mbB Patentanwälte

(56) Entgegenhaltungen:
- EP-A1- 2 743 724
- EP-A1- 2 978 216
- US-A1- 2009 224 139
- US-A1- 2010 259 570
- US-A1- 2014 145 281
- US-A1- 2014 285 707
- None

## Beschreibung

Die Erfindung betrifft Bildsensor mit einer Matrix aus Pixeln zur Erzeugung eines resultierenden Bildes mit höherem Dynamikbereich aus der Aufnahme von mindestens zwei Ursprungsbildern.

Aus dem Stand der Technik sind Bildsensoren der genannten Art bekannt, die 2 einzelne Bilder aufnehmen und dann über Bildverarbeitung die Bilder zu einem Bild mit höherem Dynamikbereich zusammenführen.

Aus der EP 2 978 216 A1 ist z.B. ein Bewegungsbildsensor mit wenigstens zwei Demodulationspixeln und einer Umschaltvorrichtung zur Umschaltung zwischen Sammeleinheiten zur Speicherung einzelner Bilder bekannt. Mit diesem Sensor können Bewegungsbildunschärfen bestimmt werden.

Es ist Aufgabe der Erfindung, einen verbesserten Bildsensor der genannten Art bereit zu stellen.

Diese Aufgabe wird, ausgehend von einem Bildsensor der eingangs genannten Art, durch einen Bildsensor nach Anspruch 1 gelöst. Vorteilhafte Ausgestaltungen sind in den weiteren abhängigen Ansprüchen angegeben.

Der erfindungsgemäße Bildsensor ist ein Bildsensor mit einer Matrix aus Pixeln zur Erzeugung eines resultierenden Bildes mit höherem Dynamikbereich aus der Aufnahme von 2 Ursprungsbildern, wobei die Pixel des Bildsensors wie Demodulationspixel ausgebildet sind, mit jeweils einem Umwandlungsbereich zur Generation von Ladungsträgern aus der empfangenen Strahlung, einer Trenneinrichtung zur zeitlichen Trennung der generierten Ladungsträger in 2 Ladungsträgerströme, einer Speichereinrichtung mit 2 Speichern zur getrennten Speicherung der Ladungsträger der 2 Ladungsträgerströme, und einer Ausleseeinrichtung zur Umwandlung der gespeicherten Ladungsträger in elektrische Signale, wobei die Trenneinrichtung dazu ausgebildet ist, die Trennung der in einer Periode generierten Ladungsträger in 2 unterschiedlichen Zeitdauern auszuführen.

Die gefüllten 2 Speicher des Pixels entsprechen dabei den zwei Ursprungsbildern. Die 2 Speicher nehmen somit Ladungsträger von unterschiedlich langer Generationsdauer auf, was unterschiedlichen Belichtungszeiten für die 2 Ursprungsbilder entspricht.

Ein Demodulationspixel ist beispielhaft in der internationalen Patentanmeldung PCT / EP2016 / 051 296 des Anmelders beschrieben.

Dies kann den Vorteil ausbilden, dass beide Ursprungsbilder zur selben Zeit im Bereich des Sensors vorliegen und daher besser verarbeitet werden können.

Die Trenneinrichtung ordnet die 2 Zeitdauern jeweils am Stück nacheinander an. Dies kann den Vorteil ausbilden, dass die Ladungsströme optimal fliessen können und eine Belichtung besonders schnell abgeschlossen ist.

Erfindungsgemäß ordnet die Trenneinrichtung die 2 Zeitdauern jeweils aufgeteilt abwechselnd an, etwa im Sinne einer Verzahnung. Dies kann den Vorteil ausbilden, dass die Erzeugung der beiden Ursprungsbilder praktisch ohne Zeitversatz erfolgt und damit ohne Zeit-Artefakte. Vorzugsweise führt die Trenneinrichtung die Trennung periodisch durch. Dies kann den Vorteil ausbilden, dass die Ansteuerung des Bildsensors einfacher wird und etwa frequenzmoduliert erfolgen kann.

Insbesondere kann eine periodische Modulation mit einem Tastgrad (duty factor) ungleich 50% erfolgen, insbesondere mit einem Tastgrad von 10% und 90% was etwa einer 9-fach längeren Belichtung des einen Speichers und damit des einen Ursprungsbildes entspricht.

Vorzugsweise ist das Pixel des Bildsensors wie ein 2-tap Demodulationspixel aufgebaut wie es im Bereich der Time-of-Flight (TOF) 3D Distanzabbildung bekannt ist.

Der Umwandlungsbereich weist ein dotiertes Substrat, auf, insbesondere ein n - - dotiertes Halbleiter-Substrat, und Elektrode zur Verarmung des Substrats, insbesondere eine transparente Rückseitenelektrode auf der Unterseite des Substrats.

Die Trenneinrichtung weist ein Driftgate auf der Oberseite des Substrats auf zur Anziehung der Ladungsträger aus dem Umwandlungsbereich in die Trenneinrichtung.

Die Trenneinrichtung weist zwei Modulationsgates auf der Oberseite des Substrats auf, insbesondere an gegenüberliegenden Stellen des Driftgates, zur abwechselnden Lenkung und Trennung der Ladungsträger.

Die Speichereinrichtung weist zwei Storagegates auf der Oberseite des Substrats auf, die jeweils einem Modulationsgate zugeordnet sind und zur Sammlung und Speicherung der zu den zugeordneten Modulationsgates hin gelenkten Ladungsträger dienen.

Die Ausleseeinrichtung weist zwei Transfergates auf der Oberseite des Substrats auf, die jeweils einem Storagegate zugeordnet sind und zur stossweisen Weitergabe der an den Storagegates gesammelten Ladungsträger an eine zugeordnete Floating Diffusion dienen.

Die Ausleseeinrichtung weist zwei Floating Diffusions auf der Oberseite des Substrats auf, insbesondere als n+ dotiertes Well, die jeweils einem Transfergate zugeordnet sind und zur Aufnahme der von den Transfergates weitergegebenen Ladungsträger und zur Einspeisung derselben als Spannung in einen AD-Wandler dienen.

Entsprechend dem Hauptanspruch kann die Trenneinrichtung auch zur Trennung in 3 oder mehr Ladungsträgerströme ausgeführt sein. Dementsprechend weist die Speichereinrichtung entsprechend 3 oder mehr Speicher auf und die Trenneinrichtung trennt in 3 oder mehr unterschiedlichen Zeitdauern. Entsprechend sind dann auch entsprechend 3 oder mehr Modulationsgates, Storagegates, Transfergates und Floating Diffusions vorzusehen.

Durch diese Anordnungen kann ein sehr effektives Demodulationspixel gebildet werden.

Weitere Merkmale der Erfindung sind in den Zeichnungen angegeben. Die jeweils genannten Vorteile können sich auch für Merkmalskombinationen realisieren in deren Zusammenhang sie nicht genannt sind.

### Überblick über die Zeichnung:

Ein Ausführungsbeispiel der Erfindung ist in der Zeichnung beispielhaft dargestellt und wird im Folgenden näher erläutert. Es zeigt:

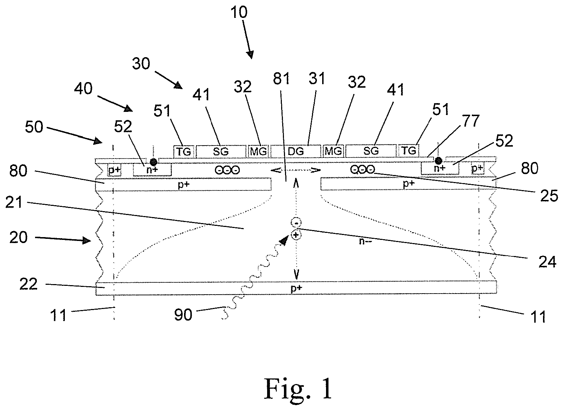

- Fig. 1: ein Pixel des erfinderischen Bildsensors

### Detaillierte Beschreibung der Zeichnung:

Fig. 1 zeigt ein Pixel 10 des Bildsensors im schematischen Seitenschnitt.

Das Pixel 10 des Bildsensors weist ein etwa 50 Mikrometer dickes, n-dotiertes Float Zone Silizium Halbleitersubstrat 21 auf, mit einem spezifischen elektrischen Flächenwiderstand von grösser oder gleich 2000 Ohm cm. An der Oberfläche des Halbleitersubstrats ist oberhalb einer nicht leitenden SiO Trennschicht 77 auf dem Substrat ein Driftgate 31 und beidseitig in symmetrischer Anordnung und jeweils voneinander mit Abstand jeweils ein Modulationsgate 32, ein Storagegate 41, ein Transfergate 51 und innerhalb des Substrats eine Floating Diffusion 52 angeordnet. Die dazu sinnvollen Layer und Kontakte sind nicht dargestellt. Eine Blende 80 ist zwischen den Gates und dem transparenten Rückseitenkontakt angeordnet und schattet die Storagegates, Transfergates und die Floating Diffusion samt dem unter den jeweiligen Gates liegenden Halbleitersubstrat gegenüber der einfallenden reflektierten Strahlung 90 ab, wobei die Blende eine Blendenöffnung 81 im Bereich unterhalb des Driftgates aufweist. Das Halbleitersubstrat ist mindestens unter dem Driftgate, insbesondere insgesamt verarmt. Das Driftgate ist mit positivem Potential beaufschlagt und bildet im Halbleitersubstrat eine Raumladungszone aus.

Die Trenneinrichtung 30 umfasst das Driftgate 31 und die Modulationsgates 32. Die Speichereinrichtung 40 umfasst die die Storagegates 41, Die Ausleseeinrichtung 50 umfasst die Transfergates 51, die Trennschicht 77, die Floating Diffusions 52, die Blende 80, die Blendenöffnung 81 sowie das zwischen Blende und den Gates befindliche Substrat, das von gleicher Art ist wie das Halbleitersubstrat 21 im Umwandlungsbereich 20. Der Umwandlungsbereich 20 umfasst das Halbleitersubstrat 21, die Rückseitenelektrode 22, und die Blende 80. Das Substrat weist eine Dicke von etwa 50 Mikrometer auf.

Die über die transparente Rückseitenelektrode 22 in das Halbleitersubstrat 21 unter dem Driftgate eindringende reflektierte IR Strahlung 90 induziert im Halbleitersubstrat Elektronen-Lochpaare 24. Die Photoelektronen werden durch die vom Driftgate 31 ausgebildete Raumladungszone zum Driftgate hin angezogen. Das Driftgate weist ein Potential von etwa 4 V auf. Die Anzahl der angezogenen Photoelektronen 25 ist proportional der empfangenen Strahlungsintensität.

Die Modulationsgates 32 können mit einem modulierten Potential beaufschlagt sein dessen Maximum zwischen den Potentialen des Driftgates 31 und des Storagegate 41 liegt und dessen Minimum unter dem des Driftgates liegt. Das Potential des Modulationsgates moduliert etwa zwischen den Werten 0 V und 5 V. Die beiden Modulationsgates sind zueinander mit inversen Potentialen betrieben, das heisst, dass das Potential des einen Modulationsgates 0 V ist, wenn das des anderen positiv ist und umgekehrt. Dann ist stets das eine Modulationsgate mit 0 V und das andere Modulationsgate mit 5 V Potential versehen. Ein Potentialminimum, hier also 0 V, führt zu einer Potentialbarriere für die Photoelektronen unter dem Driftgate, sodass keine Photoelektronen zum diesen Modulationsgate zugeordneten Storagegate gelangen können. Ein Potentialmaximum, hier also 5 V, führt zu einem Abfluss der Photoelektronen unter dem Driftgate an diesem Modulationsgate vorbei in dessen zugeordnete Storagegate.

Durch die Beaufschlagung der beiden Modulationsgates mit jeweils einem Potential das jeweils zueinander inversen Signalen entspricht, wird der Fluss der durch die empfangene Strahlungsintensität erzeugten Photoelektronen entsprechend einer Weiche gelenkt. Der so entstehende Fluss dieser Photoelektronen unter den Modulationsgates entspricht einer Multiplikation, das heisst einer Korrelation der entsprechenden Sinussignale oder Rechtecksignale mit dem empfangenen Strahlungssignal.

Die Storagegates sind mit einem höheren Potential als das Driftgate beaufschlagt und sammeln die Photoelektronen entsprechend dem Status der Modulationsgates wechselseitig unter sich. Die Storagegates haben etwa das Potential 10 V. Die unter den Storagegates durch die Photoelektronen angesammelten Ladungen entsprechen den Korrelationswerten. Die Korrelationswerte liegen somit in der Ladungsdomäne vor. Die Ansammlung der Photoelektronen unter den entsprechenden Storagegates entspricht einer zeitlichen Integration der oben erwähnten Korrelation von Korrelationssignal und empfangenen Strahlungssignal.

Zur Detektion der unter den Storagegates angesammelten Photoelektronen wird zum einen das Potential der Modulationsgates auf 0 V gelegt, um eine Potentialbarriere für die Photoelektronen in Richtung Driftgate zu bilden. Zum anderen wird das Potential der Transfergates auf einen mittleren Wert angehoben, beispielsweise 6 V, um einen bedingten Abfluss der Photoelektronen in Richtung Floating Diffusions zu ermöglichen.

Nun wird das positive Potential beider Storagegates von etwa 10 V mittels einer Zeitrampe parallel abgesenkt. Das sich dabei verändernde addierte Potential aus dem sinkenden an die Storagegates angelegten positiven Potential und dem negativen Potential der darunter befindlichen Ladung bestimmt, ob Ladung über die Transfergates abfliessen kann. Der Absenkprozess teilt sich dabei in drei Phasen ein. In einer ersten Phase der Zeitrampe ist das genannte addierte Potential noch für beide Storagegates positiver als das konstant und gleich positive Potential der Transfergates und es fliesst keine Ladung ab. In einer anschliessenden zweiten Phase der Zeitrampe ist das genannte addierte Potential für ein Storagegate positiver und für das andere Storagegate negativer als das konstant und gleich positive Potential der Transfergates. Dadurch fliesst Ladung unter dem Storagegate mit dem positiveren addierten Potential über das zugeordnete Transfergate in die zugeordnete Floating Diffusion ab, sodass das addierte Potential wieder gleich dem Potential des entsprechenden Transfergates ist. In einer abschliessenden dritten Phase der Zeitrampe sind die genannten addierten Potentiale beider Storagegates höher als die konstant gleichen Potentiale. Dadurch fliessen unter beiden Storagegates Ladungen über das jeweils zugeordnete Transfergate in die jeweils zugeordnete Floating Diffusion ab.

Die Ladungsmenge der einen geladenen Floating Diffusion wird nun mittels Source Follower in eine entsprechende Spannung gewandelt und weiter verarbeitet.

### Bezugszeichenliste:

- 10: Pixel des Bildsensors
- 11: Grenze

- 20: Umwandlungsbereich
- 21: Halbleitersubstrat
- 22: Rückseitenelektrode
- 24: Eletronen-Loch-Paare
- 25: Photo-Elektronen Entspre

- 30: Trenneinrichtung
- 31: Driftgate
- 32: Modulationsgate

- 40: Speichereinrichtung
- 41: Storagegate

- 50: Ausleseeinrichtung
- 51: Transfergate
- 52: Floating Diffusion
- 77: Trennschicht

- 80: Blende
- 81: Blendenöffnung

- 90: Einfallende Strahlung

## Patentansprüche

1. Bildsensor
- mit einer Matrix aus Pixeln (10)
- zur Erzeugung eines resultierenden Bildes mit höherem Dynamikbereich aus der Aufnahme von 2 Ursprungsbildern wobei
- die Pixel (10) des Bildsensors wie Demodulationspixel ausgebildet sind
- mit jeweils
- einem Umwandlungsbereich (20) zur Generation von Ladungsträgern aus der empfangenen Strahlung (90),
- einer Trenneinrichtung (30) zur zeitlichen Trennung der generierten Ladungsträger (24, 25) in 2 Ladungsträgerströme,
- einer Speichereinrichtung (40) mit 2 Speichern zur getrennten Speicherung der Ladungsträger der 2 Ladungsträgerströme, und
- einer Ausleseeinrichtung (50) zur Umwandlung der gespeicherten Ladungsträger in elektrische Signale,
- wobei die Trenneinrichtung (30) so dazu ausgebildet ist, dass
- die Trennung der in einer Periode generierten Ladungsträger in 2 unterschiedlichen Zeitdauern ausgeführt wird,
wobei die 2 Zeitdauern jeweils aufgeteilt abwechselnd im Sinne einer Verzahnung angeordnet sind, sodass die Erzeugung der beiden Ursprungsbilder ohne Zeitversatz und damit ohne Zeit-Artefakte erfolgt, wobei
- der Umwandlungsbereich (20) aufweist:
- ein dotiertes Substrat (21), und eine transparente Rückseitenelektrode (22) zur Verarmung des Substrats (21) auf der Unterseite des Substrats (21), und
- wobei die Trenneinrichtung (30) aufweist
- ein Driftgate (31)
- auf der Oberseite des Substrats (21)
- zur Anziehung der Ladungsträger aus dem Umwandlungsbereich (20) in die Trenneinrichtung (30) und
- zwei Modulationsgates (32)
- auf der Oberseite des Substrats (21),
- insbesondere an gegenüberliegenden Stellen des Driftgates (31),
- zur abwechselnden Lenkung und Trennung der Ladungsträger, und
- wobei die Speichereinrichtung (40) aufweist
- zwei Storagegates (41)
- auf der Oberseite des Substrats (21)
- jeweils einem Modulationsgate (32) zugeordnet
- zur Sammlung und Speicherung der zu den zugeordneten Modulationsgates (32) hin gelenkten Ladungsträger, und
- wobei die Ausleseeinrichtung (50) aufweist
- zwei Transfergates (51)
- auf der Oberseite des Substrats (21)
- jeweils einem Storagegate (41) zugeordnet
- zur stossweisen Weitergabe der an den Storagegates (41) gesammelten Ladungsträger an eine zugeordnete Floating Diffusion (52), und
- zwei Floating Diffusions (52)
- auf der Oberseite des Substrats (21)
- jeweils einem Transfergate (51) zugeordnet
- zur Aufnahme der von den Transfergates (51) weitergegebenen Ladungsträger und zur Einspeisung derselben als Spannung in einen AD-Wandler.
**dadurch gekennzeichnet, dass** eine Blende (80) mit entgegengesetzter Dotierung wie das Substrat und im Substrat zwischen den Gates (32, 41, 51) und der transparenten Rückseitenelektrode (22) angeordnet ist, sodass sie die Storagegates (41), Transfergates (51) und die Floating Diffusions (52) samt dem unter den jeweiligen Gates (32, 41, 51) liegenden Halbleitersubstrat (21) gegenüber der einfallenden Strahlung (90) abschattet, wobei die Blende (80) eine Blendenöffnung (81) im Bereich unterhalb des Driftgates (31) aufweist.

2. Bildsensor nach einem vorgenannten Anspruch, **dadurch gekennzeichnet, dass**
- die Trennung periodisch ausführt wird.

3. Bildsensor nach einem vorgenannten Anspruch, **dadurch gekennzeichnet, dass**
- der Umwandlungsbereich (20)
- ein n-dotiertes Halbleiter-Substrat (21) aufweist.

4. Bildsensor nach einem vorgenannten Anspruch, **dadurch gekennzeichnet, dass** die zwei Floating Diffusions (52)
- auf der Oberseite des Substrats (21) als n+ dotiertes Well ausgebildet sind.

## Claims

1. An image sensor,
- having a matrix of pixels (10)
- for generating a resulting image with a higher dynamic range from the acquisition of two original images,
wherein
- the pixels (10) of the image sensor are designed as demodulation pixels,
- each having
- comprises a conversion region (20) for generating charge carriers from the received radiation (90),
- a separation device (30) for temporally separating the generated charge carriers (24, 25) into two charge carrier streams,
- a memory device (40) having two memories for separately storing the charge carriers of the two charge carrier streams, and
- a read-out device (50) for converting the stored charge carriers into electrical signals,
- wherein the separation device (30) is designed such
that
- the separation of the charge carriers generated in one period takes place into two different time periods,
wherein the two time periods are each arranged so as to be divided alternately in a dovetailing manner, such that the generation of the two original images takes place without a time offset and thus without time artefacts,
wherein
- the conversion region (20) comprises:
- a doped substrate (21) and a transparent rear-side electrode (22) for depletion of the substrate (21) on the underside of the substrate (21), and
- wherein the separation device (30) comprises
- a drift gate (31)
- on the upper side of the substrate (21)
- for attracting the charge carriers from the conversion region (20) into the separation device (30), and
- two modulation gates (32)
- on the upper side of the substrate (21),
- in particular at opposite points of the drift gate (31),
- for alternately directing and separating the charge carriers, and
- wherein the memory device (40) comprises
- two storage gates (41)
- on the upper side of the substrate (21)
- each assigned to a modulation gate (32),
- for collecting and storing the charge carriers directed to the assigned modulation gates (32), and
- wherein the read-out device (50) comprises
- two transfer gates (51)
- on the upper side of the substrate (21)
- each assigned to a storage gate (41),
- for the intermittent transfer of the charge carriers collected at the storage gates (41) to an assigned floating diffusion (52), and
- two floating diffusions (52)
- on the upper side of the substrate (21)
- each assigned to a transfer gate (51),
- for receiving the charge carriers transferred by the transfer gates (51) and for feeding same as voltage into an AD converter,
**characterised in that** a diaphragm (80) with opposite doping to the substrate is arranged in the substrate between the gates (32, 41, 51) and the transparent rear-side electrode (22), such that the storage gates (41), transfer gates (51) and the floating diffusions (52), together with the semiconductor substrate (21) located under the gates (32, 41, 51), are shaded from the incident radiation (90), wherein the diaphragm (80) has a diaphragm opening (81) in the region below the drift gate (31).

2. The image sensor according to one of the preceding claims, **characterised in that**
- the separation is carried out periodically.

3. The image sensor according to one of the preceding claims, **characterised in that**
- the conversion region (20)
- has an n⁻ -doped semiconductor substrate (21).

4. The image sensor according to one of the preceding claims, **characterised in that** the two floating diffusions (52)
- are formed on the upper side of the substrate (21) as an n⁺ -doped well.

## Revendications

1. Capteur d'image
- comportant une matrice de pixels (10)
- destinée à la génération d'une image résultante présentant une plage dynamique plus élevée à partir de l'enregistrement de 2 images originales
dans lequel
- les pixels (10) du capteur d'image sont conçus sous la forme de pixels de démodulation
- comportant respectivement
- une zone de conversion (20) destinée à la génération des porteurs de charge à partir du rayonnement (90) reçu,
- un dispositif de séparation (30) destiné à la séparation temporelle des porteurs de charge (24, 25) générés en 2 flux de porteurs de charge,
- un dispositif d'accumulation (40) comportant 2 accumulateurs destinés à l'accumulation séparée des porteurs de charge des 2 flux de porteurs de charge, et
- un dispositif de lecture (50) destiné à la conversion des porteurs de charge accumulés en signaux électriques,
- dans lequel le dispositif de séparation (30) est conçu de telle sorte que
- la séparation des porteurs de charge générés en une période est effectuée en 2 périodes de temps différentes,
dans lequel les 2 périodes de temps sont divisées et disposées en alternance dans le sens d'une denture de telle sorte que la génération des deux images originales est effectuée sans décalage temporel et donc sans artefacts temporels,
dans lequel
- la zone de conversion (20) comprend :
- un substrat (21) dopé et une électrode arrière (22) transparente destinés à l'appauvrissement du substrat (21) sur la face inférieure du substrat (21), et
- dans lequel le dispositif de séparation (30) comprend
- une grille dérive (31)
- sur la face supérieure du substrat (21)
- pour attirer les porteurs de charge de la zone de conversion (20) vers le dispositif de séparation (30) et
- deux grilles de modulation (32)
- sur la face supérieure du substrat (21),
- en particulier à des points opposés de la grille dérive (31),
- pour alterner la commande et la séparation des supports de charge, et
- dans lequel le dispositif d'accumulateur (40) comprend
- deux grilles d'accumulation (41)
- sur la face supérieure du substrat (21)
- affectées respectivement à une grille de modulation (32)
- pour collecter et accumuler les porteurs de charge dirigés vers les grilles de modulation (32) affectées, et
- dans lequel le dispositif de lecture (50) comprend
- deux grilles de transfert (51)
- sur la face supérieure du substrat (21)
- affectées respectivement à une grille d'accumulation (41)
- pour le transfert par intermittence des porteurs de charge collectés aux grilles d'accumulation (41) vers une diffusion flottante (52) affectée, et
- deux diffusions flottantes (52)
- sur la face supérieure du substrat (21)
- affectées respectivement à une grille de transfert (51)
- pour recevoir les porteurs de charge transmis par les grilles de transfert (51) et pour les injecter sous forme de tension dans un convertisseur CA,
**caractérisé en ce qu'**un diaphragme (80) présentant un dopage opposé au substrat est disposé dans le substrat entre les grilles (32, 41, 51) et l'électrode arrière (22) transparente de telle sorte que les grilles d'accumulation (41), les grilles de transfert (51) et la diffusion flottante (52) conjointement avec le substrat semi-conducteur (21) situé sous les grilles (32, 41, 51) respectives font écran contre le rayonnement incident (90), le diaphragme (80) comprenant une ouverture de diaphragme (81) dans la zone sous la grille dérive (31).

2. Capteur d'image selon l'une quelconque des revendications précédentes, **caractérisé en ce que**
- la séparation est effectuée périodiquement.

3. Capteur d'image selon l'une quelconque des revendications précédentes, **caractérisé en ce que**
- la zone de conversion (20)
- comprend un substrat semi-conducteur (21) dopé n-.

4. Capteur d'image selon l'une quelconque des revendications précédentes, **caractérisé en ce que** les deux diffusions flottantes (52)
- sont conçues sur la face supérieure du substrat (21) sous la forme d'un puits dopé n+.
